# EUROPEAN PATENT APPLICATION

(11) **EP 4 765 186 A1**
(43) Date of publication of application: **24.06.2026**
(21) Application number: 24221048.2
(22) Date of filing: 18.12.2024
(51) Int. Cl.: H01J 37/244

(54) **DETECTOR MODULE**

(71) Applicant: ASML Netherlands B.V., 5500 AH Veldhoven (NL)
(72) Inventor: RODRIGUES MANSANO, Andre, Luis, 5500 AH Veldhoven (NL); VISSER, Erwin, Robert, Alexander, 5500 AH Veldhoven (NL); WANG, Shih-Chi, 5500 AH Veldhoven (NL)
(74) Representative: ASML Netherlands B.V.

(57) **Abstract**

A detector module configured to detect charged particles emitted by a sample, the detector module comprising a detector unit electrically coupled to a conversion unit; the detector unit comprising a detector substrate, comprising a detector element and a pre-amplifier circuit electrically connected to the detector element, the detector substrate comprising a first metal material for conducting signals in the detector substrate; the conversion unit comprising a conversion circuit and/or a data routing circuit, the conversion circuit and/or the data routing circuit integrated into a conversion substrate, the conversion substrate comprising a second metal material for conducting signals in the conversion substrate;
wherein the first conducting metal material is different from the second conducting metal material.

## Description

### FIELD

The present invention relates to a detector module configured to charged particles emitted by a sample.

### BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relate to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

Electron microscopes typically comprise an electron-optical device which comprises a plurality of electron-optical elements positioned along the beam path to manipulate the beam. For example, the electron-optical element(s) may lens, focus, deflect or correct the beam. At least some of these electron-optical elements or parts thereof may be manufactured via microfabrication techniques (referred to herein as MEMS process), which may include techniques such as lithography, (metal) deposition and etching. These electron-optical elements may even comprise semiconductor integrated circuits having interconnected electronic components. These semiconductor integrated circuits may constitute local storage and processing elements, but also sensor and detector elements. Different integrated circuits may be produced using different 'semiconductor nodes' which result in integrated circuits having different performance characteristics. Some parts of the integrated circuits used may require specific semiconductor nodes to comply with the performance requirement.

### SUMMARY

An aspect of the disclosure is to design elements of the electron optical device in a semiconductor node that provides the required performance.

According to a first aspect of the present invention, there is provided a detector module configured to detect charged particles emitted by a sample, the detector module comprising a detector unit electrically coupled to a conversion unit; the detector unit comprising a detector substrate, a detector element and a pre-amplifier circuit electrically connected to the detector element, the detector substrate comprising a first metal material for conducting signals in the detector substrate; the conversion unit comprising a conversion circuit and/or a data routing circuit, the conversion circuit and/or the data routing circuit integrated into a conversion substrate, the conversion substrate comprising a second metal material for conducting signals in the conversion substrate; wherein the first metal material is different from the second metal material.

According to a second aspect of the present invention, there is provided an electron-optical projection device for projecting at least one charged particle beam towards the sample, comprising at least one detector module according to an aspect of the present invention.

According to a third aspect of the present invention, there is provided an electron-optical projection device configured to project a plurality of charged particle beams towards the sample, comprising one detector module per charged particle beam, wherein the detector module is a detector module according to an aspect of the present invention.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts a single beam charged particle-optical device, for example of the assessment apparatus of Figure 1;
- Figure 5 schematically depicts a detector array in plan view;
- Figure 6 schematically depicts a detector element in cross-section;
- Figure 7 schematically depicts a detector module in cross-section;
- Figure 8 schematically depicts a detector module in cross-section;
- Figure 9 schematically depicts a detector module in cross-section;

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7-8%. It is desirable to determine defects quickly so as to maintain a high substrate throughput, defined as the number of substrates processed per hour.

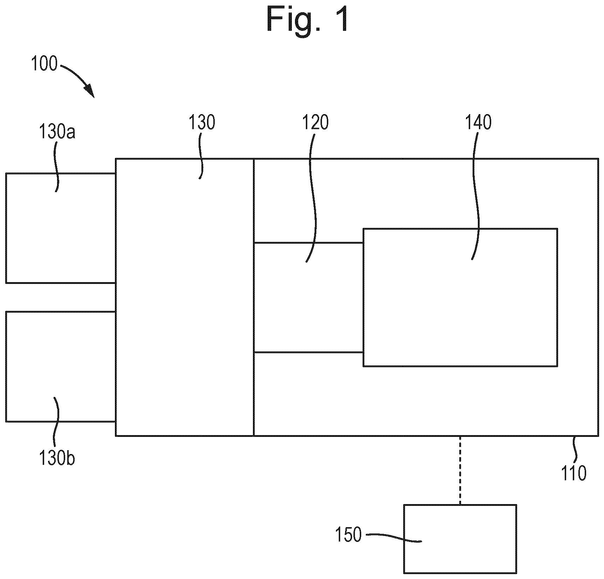

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

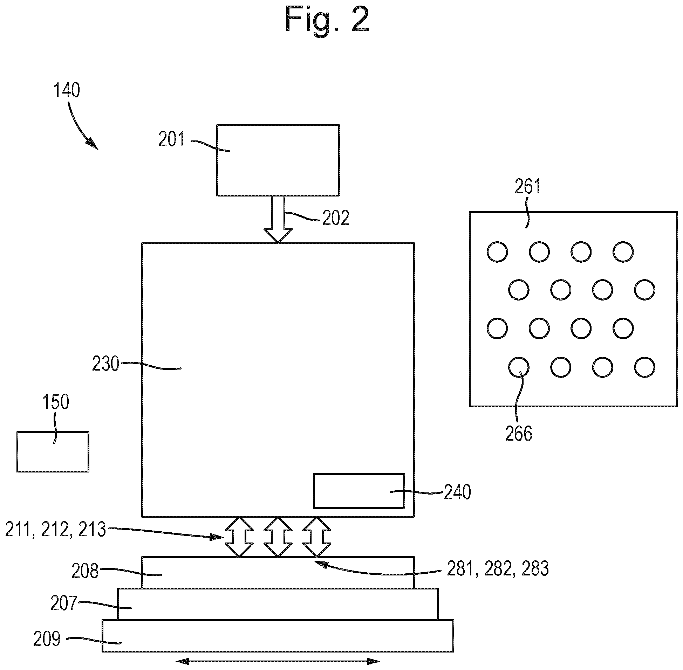

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to as array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

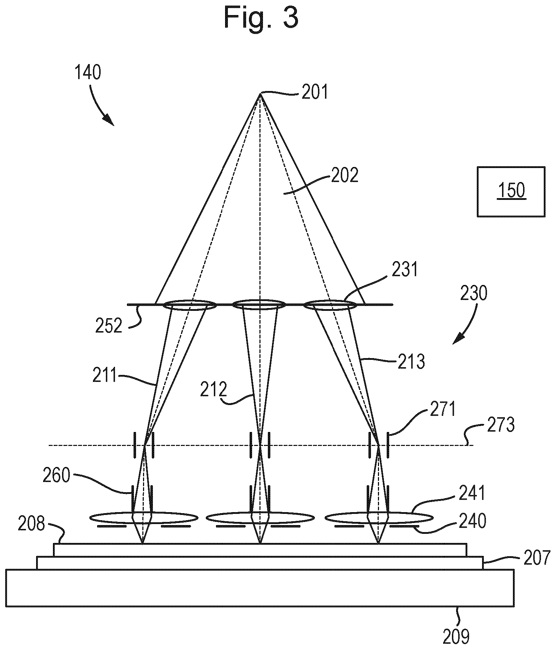

Figure 3 schematically depicts an electron-optical apparatus 140 of an assessment apparatus, e.g. the assessment apparatus 100 of Figure 1. The electron-optical apparatus 140 of

Figure 3 may be the electron-optical apparatus 140 of Figure 2 in which the electron-optical elements of the electron-optical device 230 comprise a beam limiting aperture array 252, a condenser lens array 231, a collimator array 271 for example at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam or upbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens or lens array that operates on the different beams to deflect the relative paths of the beams. The collimator array 271 may be electrostatic or magnetic. The collimator array 271 may consist of a single plate 261 (not shown in Figure 3) comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261 (not shown in Figure 3). In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to or replacing the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261 (not shown in Figure 3). Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate. It may be desirable to manufacture the stack of plates 261 by a microfabrication technique, so that the one or more of the scan deflector array 260, the corrector array (not shown), the detector array 240, the objective lens array 241 and any other components are manufactured as an integrated component. If two or more of these components are to be manufactured in an integrated component it may be necessary to use a single semiconductor node during manufacturing.

In an embodiment the detector array 240 may be integrated into the objective lens array 241, for example as part of the bottom surface of the electron-optical device 230 facing the sample 208. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

In an embodiment the assessment apparatus 100 of Figure 1 may comprise an electron-optical device array (not shown) instead of the electron-optical apparatus 140. Such an electron-optical device array is also referred to as a multi-column array. The different columns (or electron-optical devices 230) may comprise in use a plurality of beams such as a beam grid. In an embodiment the electron-optical device array comprises a plurality of electron-optical devices 230 of the type shown in Figure 2 or Figure 3.

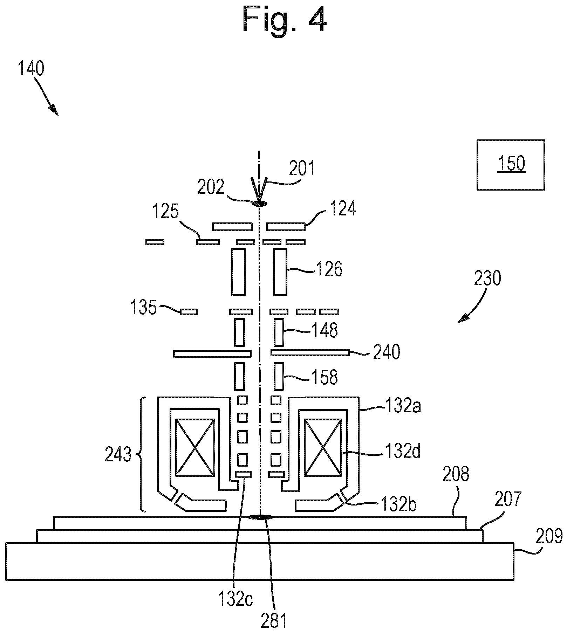

Figure 4 schematically depicts an electron-optical apparatus 140 of an assessment apparatus, e.g. the assessment apparatus 100 of Figure 1. As shown in Figure 4, in an embodiment the electron-optical apparatus 140 comprises an electron-optical device 230 that comprises a beam limiting aperture 125 (the image actually shows an array of selectable beam limiting apertures 125), a condenser lens 126, a column aperture 135 (again indicated as an array of selectable column apertures 135), an objective lens 243 and a detector array 240.

The source 201 is configured to generate a source beam 202. A gun aperture 124 blocks peripheral electrons of the source beam 202. The source beam 202 passes through the beam limiting aperture 125, the condenser lens 126 and the column aperture 135. The condenser lens 126 may be magnetic, electrostatic or a combination of magnetic and electrostatic.

In an embodiment the electron-optical device 230 comprises electromagnetic multipole, e.g. quadrupole, electron lenses. For example, the electron-optical device 230 may comprise a first multipole lens 148 and a second multipole lens 158. In an embodiment, the first multipole lens 148 and the second multipole lens 158 are used for controlling the source beam 202. For example, the first multipole lens 148 may be configured to adjust the beam current of the source beam 202. The second multipole lens 158 may be configured to adjust the size of the probe spot 281 and/or the shape of the source beam 202.

The objective lens 243 focuses the source beam 202 onto the sample 208. In an embodiment the objective lens 243 comprises a pole piece 132a, a control electrode 132b, a deflector 132c and an exciting coil 132d. In an embodiment a deflector, such as the deflector 132c or other deflectors in the objective lens 243 are configured to scan the source beam 202 across the surface of the sample 208. The detector array 240 is configured to detect signal electrons from the sample 208.

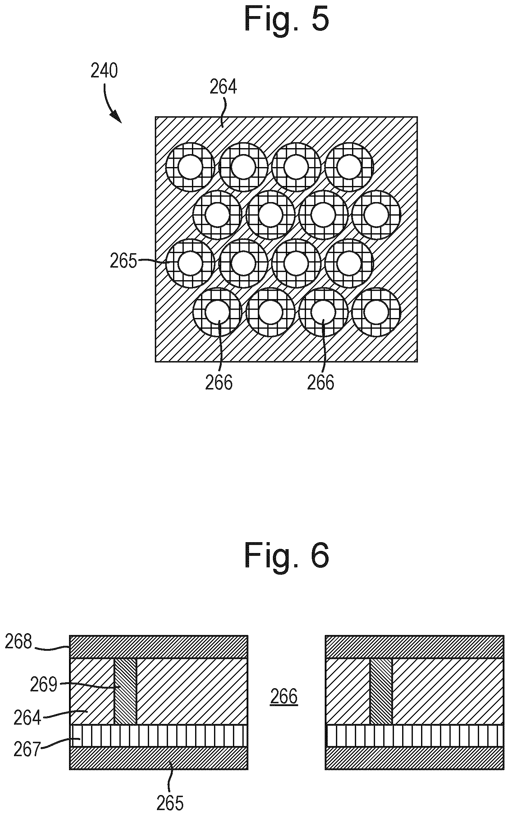

Figure 5 is a bottom view of the detector array 240 (see Figure 3) which comprises a detector substrate 264 on which are provided a plurality of detector elements 265 each surrounding a beam aperture 266. The detector array 240 may be provided at a downbeam surface of a plate 261 comprising beam apertures 266. In an embodiment, the detector elements 265 are charge capture electrodes, for example metal plates. The beam apertures 266 may be formed by etching through the detector substrate 264. In the arrangement shown in Figure 5, the beam apertures 266 are in a hexagonal close packed array. The beam apertures 266 can also be differently arranged, e.g. in a rectangular array.

Figure 6 depicts at a larger scale a part of the detector array 240 in cross section. The detector elements 265 form (part of) the bottom surface, i.e. the surface the closest to the sample 208, of the detector array 240. Between the detector elements 265 and the main body of the detector substrate 264 a logic layer 267 may be provided. At least part of the signal processing system, for example for amplification, may be incorporated into the logic layer 267.

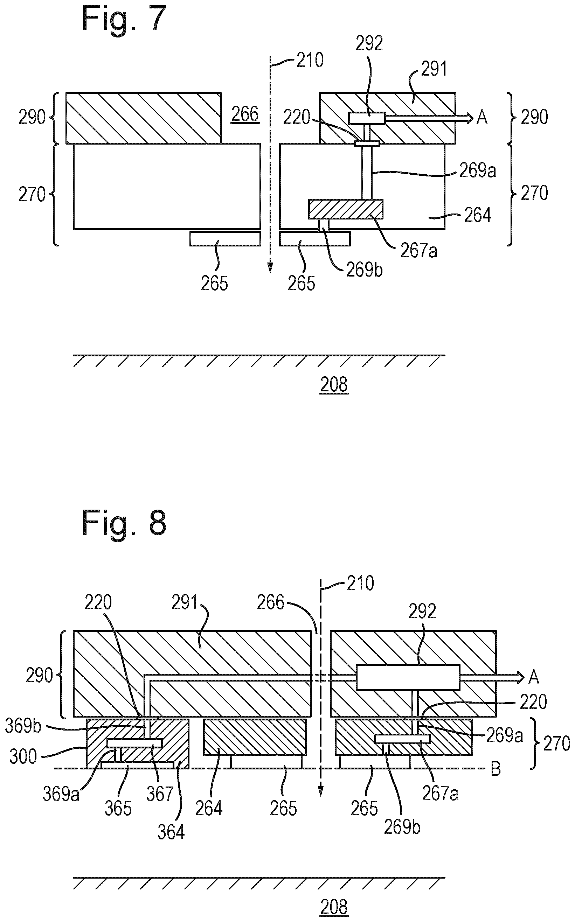

A wiring layer 268 is provided on the backside of, or within, the detector substrate 264 and connected to the logic layer 267, e.g. by through-substrate vias 269. The number of through-substrate vias 269 need not be the same as the number of beam apertures 266. In particular if the electrode signals are digitized in the logic layer 267 only a small number of through-silicon vias 269 may be required to transfer data from the logic layer 267 to any other element of the assessment apparatus 100, e.g. to the controller 150. The wiring layer 268 may include control lines, data lines and power lines. It will be noted that in spite of the beam apertures 266 there is ample space for all necessary connections. The detector array 240 may be fabricated using complementary metal-oxide semiconductor (CMOS) technology, but may also be fabricated using bipolar or other manufacturing techniques. A printed circuit board and/or other semiconductor chips may be provided on the detector array 240. The wiring layer 268 may be integrated into a substrate, which e.g. comprises a conversion circuit and/or a data routing circuit 292 (see Figure 7) to process and/or transmit the detection signal. The wiring layer 268 may include other circuits configured to condition the detection signal from the detector unit 270. When the detector array 240 is integrated into an electron-optical element (e.g. integrated into the stack of plates 261), the semiconductor node appropriate to produce the detector array 240 typically has the wiring layer 268, through-substrate via 269 and any other conductors constituted substantially of aluminum.

When an interaction product from the sample 208 is incident on the detector element 265, a detection signal is created in the detector element 265. In an example, electrons incident on the detector element 265 may generate a current.

The detection signal is processed by the logic layer 267 prior to being transmitted further, for example, to a data routing or a conversion circuit 292 (see Fig. 7). For example, the logic layer 267 may contain circuitry which (pre)amplifies the detection signal.

The substrate vias 269 are examples of conductors for transmitting a detection signal away from the detector element 265.

As the physical dimensions of structures representing circuit components on a substrate decrease in pursuit of Moore's law, the amount of data collected per unit substrate area will increase. Thus, metrology and inspection techniques will need to improve to support higher speeds of data transfer. It is desirable to provide a detector module which may be integrated into an electron-optical element which allows high speed and/or large bandwidth of data transfer to be supported. The detector module may be part of a detector array 240, such as the part of a detector array 240 shown in Figure 6.

To achieve such high speed and/or large bandwidth data transfer a different semiconductor node may be necessary compared to the semiconductor node in which the detector array 240 is produced. Such different semiconductor node for example requires metal layers having improved conductivity - for example using copper as conductive material instead of aluminum - compared to the conductive layers in the semiconductor node of the detector array 240. As such, the semiconductor node used to produce the detector array via the MEMS process may not be optimal for high speed data transmission and/or large bandwidth.

Therefore, integration of detector modules into electron-optical elements which have to support higher rates of data transfer and/or bandwidth is not possible when using the currently available and known MEMS processes that use aluminum as conductive material. Changing the MEMS process to also allow copper as conductive material would require extensive testing and development of new processes, which would be very costly and time consuming. An alternative way to still ensure high data rate while integrating the detector module into the MEMS process is to create the high data-rate parts of the detector module in a different semiconductor manufacturing node and combine the high data-rate part of the detector module via a bonding step to the remainder of the detector module. Therefore, high data-rate parts of the detector modules comprising other conductive materials such as copper may have to be manufactured separately and then coupled (e.g. bonded) to the electron-optical element in a separate manufacturing step. This may increase the complexity of the manufacturing process, for example, due to the additional complexity in aligning the to be coupled elements with other features of the electron-optical element, but this method enables high data transfer in the coupled detector element.

The current MEMS process may not allow for integration of copper-based conductors due to challenges in handling copper during the MEMS process. For example, dry etching of copper (exposing the substrate to bombardment of ions that dislodge portions of the substrate material) may require high substrate temperatures and it may be difficult to remove etch products after the dry etching. Also, deposition of copper as the conductive material may lead to copper contamination of parts of the substrate where the presence of copper is not required.

Deposition of aluminum as the conductive material may be less challenging than deposition of copper. Therefore, current MEMS processes for manufacturing electron-optical elements have been developed so that the conductors comprise aluminum. Thus, detector modules made via current MEMS processes may have been limited to aluminum conductors.

While aluminum and copper have been used as examples to illustrate the challenges with deposition of conducting materials in detector modules, similar challenges may be exhibited by other metals. Furthermore, aluminum as conductive material is typically indicated as a different semiconductor manufacturing node compared to manufacturing processes using copper.

Systems comprising aluminum as the conductive material support frequency transitions of the order of a few GHz. This may not be enough to support high rates of data transfer, which may become increasingly apparent as the amount of data collected by the detector increases.

Detector modules which do not support high speeds of data transfer (e.g. over a single line) may require many data lines to transfer detection signals from the detector module for further processing (e.g. for executing data, signal and image processing functions on the data set from the detector module). Also, the implementation of high-speed data transmission protocols may be limited.

Detector modules typically comprise a layered structure with conductors dispersed therein to conduct a detection signal from the detection element 265, as shown in Figure 6 for example. Detector modules may also comprise an aperture 266 to enable passage of a beam to the sample 208, as shown in Figure 6. Typically, the layered structure is manufactured first, which is then processed to create further features of the detector module such as the aperture 266. This may be done via techniques such as etching or cutting.

According to the present invention, there is provided a detector module which may support high rates of data transfer and which may be integrated into an electron-optical element. The present inventors have discovered a novel configuration of a detector module which overcomes the problems identified above.

According to the present invention, there is provided a detector module configured to detect charged particles emitted by a sample 208, the detector module comprising a detector unit 270 electrically coupled to a conversion unit 290. The detector unit 270 comprises the detector substrate 264, the detector element 265 and a pre-amplifier circuit 267a electrically connected to the detector element 265, the detector substrate 264 comprising a first metal material for conducting signals (e.g. the detection signal) in the detector substrate 264. The conversion unit 290 comprises a conversion circuit and/or a data routing circuit 292 and a conversion substrate 291. The conversion circuit and/or the data routing circuit 292 are integrated into the conversion substrate 291, the conversion substrate 291 comprising a second metal material for conducting signals (e.g. a detection signal from the detector unit 270) in the conversion substrate 291. The first metal material is different from the second metal material. Because of the difference between the first metal material and the second metal material, the detector unit 270 is manufactured using a different semiconductor manufacturing node compared to the conversion unit 290.

An embodiment of the present invention is shown in Figure 7, which shows a cross-section of a detector module taken through aperture 266. The aperture 266 extends through the detector element 265, the detector substrate 264, and the conversion substrate 291, to enable passage of a primary beam 210 to sample 208. When an interaction product emitted by sample 208 is incident on the detector element 265, a detection signal is created in the detector element 265. The primary beam 210 may be any one of primary beams 211, 212, 213 described with reference to Figures 2 and 3, or the primary beam 210 may be the source beam 202 described with reference to Figure 4.

The detector unit 270 is configured to collect signal particles to create a detection signal and pass the detection signal to the conversion unit 290. The detection signal passes through a pre-amplifier circuit 267a of the detector unit 270 prior to being transmitted away from the detector unit 270 toward the conversion unit 290 for further processing. The conversion unit 290 is configured to collect the detection signal from the detector unit 270, and process (e.g. condition) and/or transmit the signal for further processing. The conversion unit 290 may be configured to convert analogue signal to digital signal. The routing of the signal is indicated schematically by arrow A.

The present inventors have discovered that separating a detector module into two separately manufacturable units (the detector unit 270 and the conversion unit 290) enables integration of the detector unit 270 into an electron-optical element while using different semiconductor manufacturing nodes for the separately manufacturable units.

The detector unit 270 is manufactured using a MEMS process used for manufacturing an electron-optical element, allowing it to be integrated into the electron-optical element. The conversion unit 290 may be provided as a separate component which is electrically coupled to the detector unit 270. As the conversion unit 290 is manufactured separately to the detector unit 270 (in a different semiconductor manufacturing node), it is not bound by the constraints of the MEMS process and may contain a different metal material such as copper for conducting signals. As a result, the conversion unit 290 may support higher data frequencies than the detector unit 270, and the conversion unit 290 may be configured to process and/or transmit large volumes of data.

The detector unit 270 and the conversion unit 290 are electrically coupled, so that a detection signal may be transmitted from the detector unit 270 to the conversion unit 290. They may be electrically coupled by bonding pads 220 or other means, which are described in greater detail below.

When a charged particle is incident on the detector element 265, a detection signal is created in the detector element 265. The detection signal is transmitted from the detector element 265 through a pre-amplifier circuit 267a in the detector substrate 264 to the conversion unit 290. The pre-amplifier circuit 267a is a circuit configured to amplify the detected signal from the detector element 265. The detected signal is transmitted (conducted) through the detector substrate 264 by the first metal material and then through the conversion substrate 291 by the second metal material. The conversion unit 290 may be connected to the controller 150, and the conversion unit 290 may transmit the data to controller 150, or the like.

Conductors of the conversion unit 290 are configured to receive the detection signal from the detector unit 270 and transmit this for further processing. Conductors of the conversion unit may also comprise through-substrate vias and/or wiring made from the second metal material. The conversion unit 290 may be manufactured separate from the detector unit 270, meaning using a different semiconductor manufacturing node comprising a different metal conductive material.

The detector unit 270 may also include metal materials such as titanium, cobalt or tantalum or alloys thereof which may be used for applications such as resistance reduction in the integrated circuits of the detector unit 270. Tungsten may be used for applications such as gap filling.

Also conductors of the conversion unit 290 may include other metal materials such as titanium, cobalt or tantalum which may again be used for applications such as resistance reduction in the integrated circuits of the detector unit 270. Tungsten may be used for applications such as gap filling.

The detector unit 270 and the conversion unit 290 may be bonded to each other, as shown in Figures 7 and 8. Alternatively, the detector unit 270 and the conversion unit 290 may be bonded to a carrier substrate (not shown) configured to transmit the detection signal from the detector unit 270 to the conversion unit 290. Depending on the required data-rate of the carrier substrate, this carrier substrate may be manufactured by a semiconductor manufacturing node using aluminum as conductive material or may be manufactured by a semiconductor manufacturing node using copper as conductive material.

The first metal material may be aluminum. The first metal material may be aluminum with trace amounts of other metals and/or impurities. The first metal material may be an aluminum alloy, having a minimum aluminum content of 99.9 wt. %. Alternatively, the minimum aluminum content is 99.99 wt.%, or even 99.999 wt.%.

The second metal material may be copper. The second metal material may be copper with trace amounts of other metals and/or impurities. The second metal material may be a copper alloy, having a minimum copper content of 99.9 wt. %. Alternatively, the minimum copper content is 99.99 wt.%, or even 99.995 wt.%.

The pre-amplifier circuit 267a may be provided as part of the logic layer 267, as shown in Figure 6. The pre-amplifier circuit 267a may be provided as part of a logic element, which is embedded within the detector substrate 264, as shown in Figure 7.

The pre-amplifier circuit 267a may be embedded within the detector substrate 264 and connected to the detector element 265 by conductors such as a through-substrate vias 269a, 269b, as shown in Figure 7 for example. The detector unit through-substrate vias 269a, 269b comprise or consist substantially of the first metal material, e.g. they may be aluminum through-substrate vias. The detector unit 270 may have further logic circuits integrated therein, with the first metal material as the conductor.

Various configurations of the detector unit 270 and the conversion unit 290 are possible, without departing the scope of the invention. For example, in Figure 7 the pre-amplifier circuit 267a is shown as being disposed on the right-hand side of the aperture 266, but it may be disposed on any side of the aperture 266 and may even be partially circumventing the aperture 266. The detector element 265 may be a continuous element (such as ring) or may comprise two or more segments, for example each having a pre-amplifier circuit 267a connected thereto.

The logic element and/or logic layer 267 may comprise one or more of the following: an amplifier configured to amplify the detection signal received from the detector element, a PIN junction, and a diode. The logic element and/or logic layer 267 may comprise conductors comprising or consisting substantially of the first metal material.

The detector unit 270 is electrically coupled to the conversion unit 290. In an embodiment, the detector unit 270 is bonded to the conversion unit 290 by a bonding pad 220. The bonding pad 220 may comprise an electrical conductor, such as gold, tungsten, or a conductive glue. A plurality of bonding pads 220 may be provided at the interface of the detector unit 270 and the conversion unit 290 where electrical coupling is required.

The detector unit 270 and the conversion unit 290 may be provided as a 2.5D integrated circuit, in which the detector unit 270 and the conversion unit 290 are provided in a single package without stacking them in a three-dimensional integrated circuit. Alternatively, they may be provided as a 3D integrated circuit, wherein the detector unit 270 and the conversion unit 290 are stacked or bonded. Alternatively, the detector unit 270 and the conversion unit 290 may be bonded to a carrier (not shown). A 3D integrated circuit may be more compact than the 2.5D integrated circuit. The carrier may comprise conductors comprising the same metal as the conversion unit 290 or the detector unit 270, depending on the data rate which the carrier may need to convert.

The detector unit 270 and the conversion unit 290 may be electrically coupled by bonding of the detector substrate 264 to the conversion substrate 291. Alternatively, they may be electrically coupled by bonding of the detector substrate 264 and the conversion substrate 291 to the carrier (not shown).

Bonding techniques comprise fusion bonding, hybrid bonding and adhesive bonding.

Fusion bonding creates a permanent connection between the surfaces of dielectric components (such as a surface of the detector substrate 264 and a surface of the conversion substrate 291).

Fusion bonding comprises the following steps. In a first step, the to-be-connected components (for example the detector substrate 264 and the conversion substrate 291) are aligned. In a second step, the surfaces are brought together so that they become bonded via van der Waals forces and/or hydrogen bonds. This second step may be performed at room temperature and under atmospheric conditions. In a third step, the two components are heated which causes formation of covalent bonds between dielectric portions of the two components (for example, formation of covalent Si-Si bonds between silicon substrates).

To create a strong van der Waals bond between the to-be-bonded surfaces, it may be preferable to process the two to-be-bonded surfaces so that they are clean and smooth.

Electrical connection between the two components may be formed after fusion bonding.

Hybrid bonding creates a permanent connection between the surfaces of dielectric components (such as a surface of the detector substrate 264 and a surface of the conversion substrate 291). In hybrid bonding, electrical contact between metal portions of the first component surface with metal portions of the second component surface may be achieved during the bonding process. The metal portions of the first and second component surfaces may be exposed edges of electrical contacts within the first component and the second component respectively. Hybrid bonding may result in most or all of the dielectric portions of the first component being bonded to dielectric portions of the second component at least partly via covalent bonds.

Hybrid bonding comprises the following steps. In a first step, the two to-be-bonded components are aligned. Preferably, they are aligned so that metallic portions of the surface first component are aligned with the metallic portions of the surface of the second component. In a second step, the surfaces are brought together so that they become bonded via van der Waals forces and/or hydrogen bonds. This second step may be performed at room temperature and under atmospheric conditions. In a third step, the two components are heated which causes formation of covalent bonds between dielectric portions of the to-be-bonded components (for example, formation of covalent Si-Si bonds between silicon substrates). During heating, the metallic portions expand and come into contact with each other, so that they become fused and form an electrical contact.

To create a strong van der Waals bond between the surfaces, it may be preferable to process the two to-be-bonded surfaces so that they are clean and smooth.

In addition, bonding pads 220 may be provided in places where electrical contact of the two components is desired.

As an alternative to hybrid bonding, adhesive bonding may be used. Adhesive bonding comprises the use of an adhesive to bond the surfaces of components, with conductive bonding pads 220 provided between metallic portions of the first and second components. The first component and the second component may be the detector substrate 264, conversion substrate 291 and/or carrier. If the adhesive has low electrical conductivity, it is preferable to avoid areas where the components become electrically coupled.

A detector module manufactured via hybrid bonding may comprise the features of Figure 7.

The detector unit 270 and the conversion unit 290 are coupled (whether by fusion bonding, hybrid bonding or adhesive bonding) such that the detector unit 270 and the conversion unit 290 are electrically coupled. In other words, the detector unit 270 is bonded to the conversion unit 290 so that an electrical connection may be formed between the conductors in the detector substrate 264 and the conductors in the conversion substrate 291. Coupling may be achieved by forming an electrical contact between an exposed area of the metal conduction means of the detector substrate 264 (e.g. an exposed end of a through-substrate via) and an exposed area of the metal conduction means of the conversion substrate 291 (e.g. an exposed end of a through-substrate via). Prior to bonding, the exposed areas of the metal conductors of the detector substrate 264 and the conversion substrate 291 have to be aligned. In a similar manner, if the detector unit 270 and the conversion unit 290 are bonded to a carrier, the exposed areas of the metal conductors of the carrier, the detector substrate 264 and the conversion substrate 291 are aligned prior to bonding so that the desired electrical connections may be formed. Accordingly, the carrier, the detector substrate 264 and the conversion substrate 291 are electrically coupled after bonding.

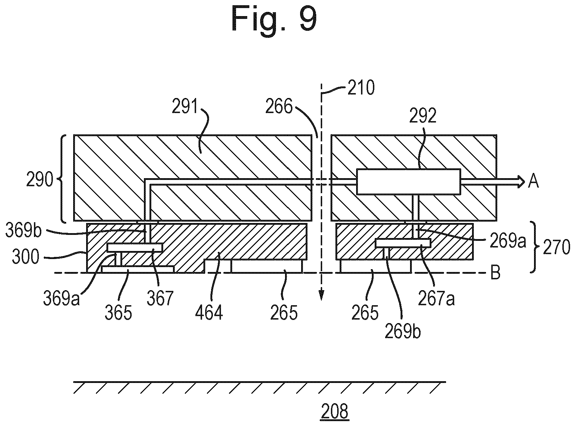

The description of the various components of Figure 7 applies equally to the embodiments shown on Figures 8 and 9. Figures 8 and 9 show embodiments of the present invention additionally comprising a sensor unit 300.

In an embodiment, the sensor unit 300 comprises a sensor element 365 disposed on a sensor substrate 364. In the current embodiment, the sensor element 365 is arranged to face sample 208. The sensor substrate 364 is electrically coupled to the conversion unit 290. The conversion unit 290 may be configured to process a signal from the sensor unit 300 (referred to as a sensor signal). The sensor unit 300 comprises a sensor element 365 electrically connected to a sensor pre-amplifier 367 (which is optional) and to the conversion unit 290. In an embodiment, the sensor element 365 is connected to the sensor pre-amplifier 367 by through-substrate vias 369a, 369b. However, other configurations of the sensor pre-amplifier 367 are possible, such as a sensor pre-amplifier 367 disposed in direct electrical contact with the sensor element 365 and connected to the conversion unit 290 by a through-substrate via. The sensor pre-amplifier 367 may comprise a pre-amplifier circuit.

The sensor unit 300 may comprise a metal material to conduct sensor signals from the sensor element 365 to the conversion unit 290. The metal material of the sensor unit 300 may be the first metal material, such as aluminum or the second material, such as copper.

In the current embodiment, the sensor element 365 may be configured to measure a distance of the detector element 265 a sample 208, for example in an embodiment of a capacitive distance sensor. Alternatively, the sensor element 365 may be a residual gas analyzer. A plurality of sensor units 300 may be provided, and optionally, each configured to measure a separate parameter. Each of the one or more sensor units 300 may be provided with a plurality of sensor elements 365. For example, there may be one, two, three, four, five, six, seven, eight, nine, ten or more sensor elements 365. A sensor signal generated by at least some of these plurality of sensor elements 365 is transmitted to the conversion unit 290.

The sensor unit 300 and the detector unit 270 may be bonded to the conversion substrate 291 of the conversion unit 290 via any of the techniques described above (e.g. via fusion bonding, hybrid bonding or adhesive bonding). The sensor unit 300 may be bonded to the conversion substrate 291 via one or more bonding pads 220.

The sensor element 365 and the detector element 265 may be coplanar. This may be convenient when the sensor element 365 is a distance sensor, because the height of the sensor element 365 above the sample 208 will correspond to that of the detector element 265.

In an embodiment, the sensor unit 300 and the detector unit 270 are integral. The sensor substrate 364 and the detector substrate 294 are integrated into a single substrate 494, as shown in Figure 9.

The sensor unit 300, the detector unit 270 and the conversion unit 290 may be provided as a 2.5D integrated circuit, in which the sensor unit 300, the detector unit 270 and the conversion unit 290 are provided in a single package without stacking them in a three-dimensional integrated circuit.

Alternatively, they may be provided as a 3D integrated circuit, wherein the sensor unit 300, the detector unit 270 and the conversion unit 290 are staked or bonded to a carrier. A 3D integrated circuit may be more compact than the 2.5D integrated circuit. The carrier may comprise conductors comprising the same metal as the conversion unit 290.

The conversion circuit and/or a data routing circuit 292 may be to process and/or transmit the sensor signal from the sensor unit 300. The conversion circuit and/or a data routing circuit 292 may be to configured to modulate detection signal from the detector unit 270 based on the sensor signal from the sensor unit 300, e.g. modulate the detection signal based on the distance of the detector element 265 above the sample 208 or based on the partial pressure of residual gas.

Any of the detector substrate 264, conversion substrate 291, the carrier, the sensor substrate 364 and/or the single substrate 494 may be semiconductor substrates. These semiconductor substrates may comprise silicon or gallium arsenide. In an embodiment, each of the substrate consists of the semiconductor substrate and the conductors dispersed therein.

Any of the detection modules described herein may be disposed in an electron-optical projection device for projecting at least one charged particle beam towards the sample. For example, one or more detection modules may be disposed in an electron-optical projection device configured to project a plurality of charged particle beams towards the sample, comprising one detector module per charged particle beam.

In an embodiment the electron-optical apparatus 140 comprises a secondary electron-optical device (not shown) comprising the detector array 240. In such an embodiment a beam separator (e.g. a Wien filter, not shown) typically is arranged to deflect the path of the signal electrons towards the secondary electron-optical device. The secondary electron-optical device subsequently directs the signal electrons towards the detector array 240 and focuses the signal electrons (e.g. secondary electrons) onto the detector array 240.

Features in electron-optical plates may be manufactured using techniques from microelectromechanical systems (MEMS) (i.e. using MEMS manufacturing techniques). MEMS are miniaturized mechanical and electromechanical elements that are made using microfabrication techniques. Merely as an example, a collimator array may be formed using MEMS manufacturing techniques so as to be spatially compact. As another example, a scan deflector array may be formed using MEMS manufacturing techniques.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

Exemplary embodiments of the invention are set out in the following numbered clauses:
Clause 1. A detector module configured to detect charged particles emitted by a sample, the detector module comprising a detector unit electrically coupled to a conversion unit;
   the detector unit comprising a detector substrate, a detector element and a pre-amplifier circuit electrically connected to the detector element, the detector substrate comprising a first metal material for conducting signals in the detector substrate;
   the conversion unit comprising a conversion circuit and/or a data routing circuit, the conversion circuit and/or the data routing circuit integrated into a conversion substrate, the conversion substrate comprising a second metal material for conducting signals in the conversion substrate;
   wherein the first metal material is different from the second metal material.
Clause 2. The detector module according to clause 1, wherein the first metal material conducts signals in the detector substrate from the detector element to conversion unit.
Clause 3. The detector module according to clause 1 or clause 2, wherein the detector unit and the conversion unit are bonded to a carrier configured to transmit signals between the detector unit and the conversion unit, or the detector unit and the conversion unit are bonded to each other.
Clause 4. The detector module according to any of the preceding clauses, wherein the first metal material is aluminum.
Clause 5. The detector module according to clause 4, wherein the first metal material consists of at least 99.9 wt. % aluminum.
Clause 6. The detector module according to any of the preceding clauses, wherein the second metal material is copper.
Clause 7. The detector module according to clause 6, wherein the second metal material consists of at least 99.9 wt. % copper.
Clause 8. The detector module according to any of the preceding clauses, wherein the detector substrate comprises a logic element comprising the pre-amplifier circuit, wherein the logic element is at least partially in contact with the detector element.
Clause 9. The detector module according to any of the preceding clauses, wherein detector substrate comprises a logic element comprising the pre-amplifier circuit, wherein the logic element is integrated in the detector substrate, and is connected to the detector element and/or to the conversion circuit by respective through-substrate vias comprising the first metal material.
Clause 10. The detector module according to clause 9, wherein the respective through-substrate vias each consist of at least 99.9 wt. % of the first metal material.
Clause 11. The detector module according to any one of clauses 8 to 10, wherein the logic element comprises the first metal material.
Clause 12. The detector module according to any one of clauses 8 to 11, wherein the logic element is configured to process a signal from the detection segment prior to the signal passing to the conversion unit.
Clause 13. The detector module according to any of the preceding clauses, wherein the detector substrate comprises one or more of the following electrically connected to the detector element: an amplifier configured to amplify signal received from the detector element; a PIN junction; and a diode.
Clause 14. The detector module according to any of the preceding clauses, wherein the detector unit is coupled to the conversion unit by a bonding pad.
Clause 15. The detector module according to clause 14, wherein the bonding pad comprises an electrical conductor.
Clause 16. The detector module according to clause 15, wherein the bonding pad comprises one of gold, tungsten or a conductive adhesive.
Clause 17. The detector module according to any of the preceding clauses, wherein the conversion unit is configured to process and transmit a signal from the detector unit.
Clause 18. The detector module according to any of the preceding clauses, wherein the detector unit comprises an aperture configured for passage of a charged-particle beam to the sample.
Clause 19. The detector module according to any of the preceding clauses, further comprising:
   a sensor unit comprising a sensor element disposed on a sensor substrate, the sensor element configured to face the sample, wherein the sensor unit is electrically coupled to the conversion unit.
Clause 20. The detector module according to clause 19, wherein the conversion unit is further configured to process a signal from the sensor unit.
Clause 21. The detector module according to clause 19 or clause 20, wherein the sensor unit and the detector unit are configured so that the sensor element and the detector element are coplanar.
Clause 22. The detector module according to any one of clauses 19 to 21, wherein the sensor unit is configured to measure a distance of the detector element above a sample surface.
Clause 23. The detector module according to any one of clauses 19 to 22, wherein the sensor substrate and the detector substrate are integrated into a single substrate.
Clause 24. An electron-optical projection device for projecting at least one charged particle beam towards the sample, comprising at least one detector module according to any one of clauses 1 to 23.
Clause 25. An electron-optical projection device configured to project a plurality of charged particle beams towards the sample, comprising one detector module per charged particle beam, wherein the detector module is a detector module according to any one of clauses 1 to 23.
Clause 26. A detector module configured to detect charged particles emitted by a sample, the detector module comprising a detector unit electrically coupled to a conversion unit;
   the detector unit comprising a detector substrate, a detector element and a pre-amplifier circuit electrically connected to the detector element, the detector substrate comprising materials and/or structure dimensions associated with a first semiconductor manufacturing node;
   the conversion unit comprising a conversion circuit and/or a data routing circuit, the conversion circuit and/or the data routing circuit integrated into a conversion substrate, the conversion substrate comprising materials and/or structure dimensions associated with a second semiconductor manufacturing node;
   wherein the first semiconductor manufacturing node is different from the second semiconductor manufacturing node.
Clause 27. The detector module according to clause 26, wherein the detector unit and the conversion unit are bonded to a carrier configured to transmit signals between the detector unit and the conversion unit, or the detector unit and the conversion unit are bonded to each other.
Clause 28. The detector module according to any of the clauses 26 to 27, wherein the first semiconductor manufacturing node comprises aluminum as metal material for conducting power and/or signals inside the detector unit.
Clause 29. The detector module according to any of the clauses 26 to 28, wherein the second semiconductor manufacturing node comprises copper as metal material for conducting power and/or signals inside the conversion unit.
Clause 30. The detector module according to any of the clauses 26 to 29, wherein a smallest structure dimension in the second semiconductor manufacturing node is smaller than a smallest structure in the first semiconductor manufacturing node.
Clause 31. The detector module according to any of the clauses 26 to 30, wherein the detector substrate comprises a logic element comprising the pre-amplifier circuit, wherein the logic element is at least partially in contact with the detector element.
Clause 32. The detector module according to any of the clauses 26 to 31, wherein detector substrate comprises a logic element comprising the pre-amplifier circuit, wherein the logic element is integrated in the detector substrate, and is connected to the detector element and/or to the conversion circuit by respective through-substrate vias.
Clause 33. The detector module according to any one of clauses 31 to 32, wherein the logic element is configured to process a signal from the detection segment prior to the signal passing to the conversion unit.
Clause 34. The detector module according to any of the clauses 26 to 33, wherein the detector substrate comprises one or more of the following electrically connected to the detector element: an amplifier configured to amplify signal received from the detector element; a PIN junction; and a diode.
Clause 35. The detector module according to any of the clauses 26 to 34, wherein the detector unit is coupled to the conversion unit by a bonding pad.
Clause 36. The detector module according to clause 35, wherein the bonding pad comprises one of gold, tungsten or a conductive adhesive.
Clause 37. The detector module according to any of the clauses 26 to 36, wherein the conversion unit is configured to process and transmit a signal from the detector unit.
Clause 38 The detector module according to any of the clauses 26 to 37, wherein the detector unit comprises an aperture configured for passage of a charged-particle beam to the sample.
Clause 39. The detector module according to any of the clauses 26 to 38, further comprising:
   a sensor unit comprising a sensor element disposed on a sensor substrate wherein the sensor unit is electrically coupled to the conversion unit.
Clause 40. The detector module according to clause 39, wherein the conversion unit is further configured to process a signal from the sensor unit.
Clause 41. The detector module according to clause 39 or clause 40, wherein the sensor unit and the detector unit are configured so that the sensor element and the detector element are coplanar.
Clause 42. The detector module according to any one of clauses 39 to 41, wherein the sensor unit is configured to measure a distance of the detector element above a sample surface.
Clause 43. The detector module according to any one of clauses 39 to 42, wherein the sensor substrate and the detector substrate are integrated into a single substrate.
Clause 44. An electron-optical projection device for projecting at least one charged particle beam towards the sample, comprising at least one detector module according to any one of clauses 26 to 43.

The following reference numerals are used throughout the description and drawings:

### List of reference numerals:

100 assessment apparatus
110 vacuum chamber (main chamber)
120 load lock chamber
124 gun aperture
125 beam limit aperture
130 EFEM
130a first loading port
130b second loading port
132a pole piece
132b control electrode
132c deflector
132d exciting coil
135 column aperture
140 electron-optical apparatus (electron beam apparatus, electron apparatus)
148 first multipole lens
150 controller
158 second multipole lens
201 source
202 source beam
207 sample holder
208 sample
209 actuatable stage
210 primary beam
211, 212, 213 primary beams (sub-beams, beamlets)
220 bonding pad
230 electron-optical device (electron-optical column)
231 condenser lens array
240 detector array
241 objective lens array
243 objective lens
252 beam limiting aperture array
260 scan deflector array
261 plate
264 detector substrate
265 detector elements
266 beam apertures
267 logic layer
267a pre-amplifier circuit
268 wiring layer
269, 269a, 269b through-substrate vias
270 detector unit
271 collimator array
273 intermediate focus plane
281-283 probe spots
290 conversion unit
291 conversion substrate
292 conversion circuit/data routing circuit
300 sensor unit
364 sensor substrate
367 sensor pre-amplifier369a, 369b through-substrate vias
494 single substrate

## Claims

1. A detector module configured to detect charged particles emitted by a sample, the detector module comprising a detector unit electrically coupled to a conversion unit;
the detector unit comprising a detector substrate, a detector element and a pre-amplifier circuit electrically connected to the detector element, the detector substrate comprising a first metal material for conducting signals in the detector substrate;
the conversion unit comprising a conversion circuit and/or a data routing circuit, the conversion circuit and/or the data routing circuit integrated into a conversion substrate, the conversion substrate comprising a second metal material for conducting signals in the conversion substrate;
wherein the first metal material is different from the second metal material.

2. The detector module according to claim 1, wherein the first metal material conducts signals in the detector substrate from the detector element to conversion unit.

3. The detector module according to claim 1 or claim 2, wherein the detector unit and the conversion unit are bonded to a carrier configured to transmit signals between the detector unit and the conversion unit, or the detector unit and the conversion unit are bonded to each other.

4. The detector module according to any of the preceding claims, wherein the first metal material is aluminum.

5. The detector module according to any of the preceding claims, wherein the second metal material is copper.

6. The detector module according to any of the preceding claims, wherein detector substrate comprises a logic element comprising the pre-amplifier circuit, wherein the logic element is integrated in the detector substrate, and is connected to the detector element and/or to the conversion circuit by respective through-substrate vias comprising the first metal material.

7. The detector module according to claim 6, wherein the logic element comprises the first metal material.

8. The detector module according to claim 6 or claim 7, wherein the logic element is configured to process a signal from the detection segment prior to the signal passing to the conversion unit.

9. The detector module according to any of the preceding claims, wherein the detector substrate comprises one or more of the following electrically connected to the detector element: an amplifier configured to amplify signal received from the detector element; a PIN junction; and a diode.

10. The detector module according to any of the preceding claims, wherein the detector unit is coupled to the conversion unit by a bonding pad, and wherein the bonding pad comprises one of gold, tungsten or a conductive adhesive.

11. The detector module according to any of the preceding claims, wherein the conversion unit is configured to process and transmit a signal from the detector unit.

12. The detector module according to any of the preceding claims, wherein the detector unit comprises an aperture configured for passage of a charged-particle beam to the sample.

13. The detector module according to any of the preceding claims, further comprising:
a sensor unit comprising a sensor element disposed on a sensor substrate, wherein the sensor unit is electrically coupled to the conversion unit.

14. The detector module according to claim 13, wherein the sensor unit is configured to measure a distance of the detector element above a sample surface.

15. An electron-optical projection device for projecting at least one charged particle beam towards the sample, comprising at least one detector module according to any one of claims 1 to 14.
